(19) Europäisches Patentamt
European Patent Office
Office européen des brevets

(11) **EP 4 593 076 A1**

(12) **EUROPÄISCHE PATENTANMELDUNG**

(43) Veröffentlichungstag:
30.07.2025  Patentblatt 2025/31

(21) Anmeldenummer: 24153588.9

(22) Anmeldetag: **24.01.2024**

(51) Internationale Patentklassifikation (IPC):
**H01L 23/373** (2006.01)    **H05K 1/03** (2006.01)

(52) Gemeinsame Patentklassifikation (CPC):
**H01L 23/3735; H05K 1/0306**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Heraeus Electronics GmbH & Co. KG
63450 Hanau (DE)**

(72) Erfinder:
• **Wacker, Richard
63450 Hanau (DE)**
• **Sipos, Fabian**
307221 Chisoda (RO)
• **Batista, Ciprian**
307221 Chisoda (RO)
• **Leah, Andrei-Stefan**
307221 Chisoda (RO)

(74) Vertreter: **Heraeus IP
Heraeus Business Solutions GmbH
Intellectual Property
Heraeusstraße 12-14
63450 Hanau (DE)**

(54) **METALL-KERAMIK-SUBSTRAT MIT KONTAKTBEREICH**

(57)  Die Erfindung betrifft ein Metall-Keramik-Substrat, ein elektronisches Bauteil aufweisend ein Metall-Keramik-Substrat und ein Verfahren zur Herstellung eines Metall-Keramik-Substrats. Das Metall-Keramik-Substrat weist auf: a) einen Keramikkörper, der eine Hauptbegrenzungsfläche aufweist, b) eine Metallschicht, die eine Hauptbegrenzungsfläche aufweist, wobei die Metallschicht flächig mit dem Keramikkörper verbunden ist, und wobei die Metallschicht einen Strukturierungsbereich aufweist, der (i) bereichsweise festes Material und (ii) bereichsweise nicht-festes Material umfasst, und c) einen auf der Metallschicht angeordneten Kontaktbereich aufweisend Silber, wobei in einem Querschnitt durch das Metall-Keramik-Substrat senkrecht zur Hauptbegrenzungsfläche des Keramikkörpers der Strukturierungsbereich eine Geometrie aufweist, wobei folgendes Erfordernis erfüllt ist:

$$S (BC_{solid}) / S (BC_{total}) > 60\%,$$

wobei: $S (BC_{total})$ für die gesamte Länge der Strecke zwischen den Punkten B und C steht und $S (BC_{solid})$ für die Länge der Strecke zwischen den Punkten B und C steht, die festes Material schneidet. Das feste Material weist in dem Bereich, der an der oberen Hälfte einer Konturlinie anliegt, einen erhöhten Gehalt an Silber auf.

Figur 2

**Beschreibung**

Die vorliegende Erfindung betrifft ein Metall-Keramik-Substrat, ein elektronisches Bauteil aufweisend ein Metall-Keramik-Substrat und ein Verfahren zur Herstellung eines Metall-Keramik-Substrats.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Metallfolien bei Temperaturen von etwa 650 bis 1000°C mit Keramikkörpern verbunden werden, wobei ein spezielles Lot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Alternativ dazu können auch silberfreie Lote zur Verbindung von Metallfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau von elektronischen Bauteilen werden Metall-Keramik-Substrate üblicherweise mit einem Chip bestückt. Für die Bestückung des Metall-Keramik-Substrats mit einem Chip ist es in der Regel erforderlich, dass der mit dem Chip zu bestückende Bereich des Metall-Keramik-Substrats mit einem silberhaltigen Kontaktbereich versehen ist. Durch die Bereitstellung des silberhaltigen Kontaktbereichs wird eine leichtere Anbindung des Chips mit dem Metall-Keramik-Substrat durch gängige Verfahren wie Sintern oder Löten ermöglicht. Zur Schaffung des Kontaktbereichs wird das Metall-Keramik-Substrat in der Regel zunächst bereichsweise mit einer Ätzlösung behandelt, um eine gewünschte Strukturierung auszubilden. Danach wird der Kontaktbereich vorgesehen, indem bereichsweise eine silberhaltige Beschichtung auf der Oberfläche des strukturierten Metall-Keramik-Substrats erzeugt wird.

Die so hergestellten Metall-Keramik-Substrate sind als Teil von elektronischen Bauteilen im Betrieb üblicherweise hohen Temperaturwechseln ausgesetzt. Während in Betriebspausen - je nach Umgebung - die Temperaturen zum Beispiel -20°C oder weniger betragen können, kann die Temperatur der Metall-Keramik-Substrate im Betrieb leicht auf über 150°C ansteigen. Diesen Temperaturunterschieden sind die Metall-Keramik-Substrate regelmäßig wiederholt ausgesetzt. Dabei kann es aufgrund der unterschiedlichen Wärmeausdehnungskoeffizienten des Metalls und der Keramik bei wiederholten Temperaturwechseln zu einer Ablösung der Metallschicht vom Keramikkörper kommen (Peeling), die einen Leistungsausfall zur Folge hat. Damit ist eine hohe Temperaturwechselbeständigkeit ein maßgebliches Kriterium für die Eignung von Metall-Keramik-Substraten für Anwendungen in der Elektronik, insbesondere in der Leistungselektronik.

Wünschenswert wäre es daher, die Temperaturwechselbeständigkeit von Metall-Keramik-Substraten weiter zu erhöhen.

Eine Aufgabe der vorliegenden Erfindung besteht daher darin, ein Metall-Keramik-Substrat zur Verfügung zu stellen, das eine erhöhte Temperaturwechselbeständigkeit aufweist.

Diese Aufgabe wird gelöst durch das Metall-Keramik-Substrat von Anspruch 1. Die Erfindung stellt daher ein Metall-Keramik-Substrat bereit aufweisend

a) einen Keramikkörper, der eine Hauptbegrenzungsfläche aufweist,
b) eine Metallschicht, die eine Hauptbegrenzungsfläche aufweist, wobei die Metallschicht flächig mit dem Keramikkörper verbunden ist, und wobei die Metallschicht einen Strukturierungsbereich aufweist, der

(i) bereichsweise festes Material und
(ii) bereichsweise nicht-festes Material
umfasst, und

c) einen auf der Metallschicht angeordneten Kontaktbereich aufweisend Silber,

wobei

in einem Querschnitt durch das Metall-Keramik-Substrat senkrecht zur Hauptbegrenzungsfläche des Keramikkörpers der Strukturierungsbereich eine Geometrie aufweist, wobei folgendes Erfordernis erfüllt ist:

$$S\,(BC_{solid})\,/\,S\,(BC_{total}) > 60\%,$$

wobei:

S ($BC_{total}$) für die gesamte Länge der Strecke zwischen den Punkten B und C steht und
S ($BC_{solid}$) für die Länge der Strecke zwischen den Punkten B und C steht, die festes Material schneidet, wobei die Punkte B und C wie folgt bestimmt werden:

1. die Ausgleichsgerade zwischen dem Keramikkörper und der Metallschicht wird bestimmt;
2. die Konturlinie wird bestimmt, die das feste Material vom nicht-festen Material trennt;
3. auf einer Senkrechten zur Ausgleichsgeraden wird im Abstand von 150 $\mu$m zur Ausgleichsgeraden der Punkt A ermittelt, in dem die Senkrechte zur Ausgleichsgeraden die Konturlinie schneidet;
4. auf einer Senkrechten zur Ausgleichsgeraden wird im Abstand von 80 $\mu$m zur Ausgleichsgeraden der Punkt B ermittelt, in dem die Senkrechte zur Ausgleichsgeraden die Konturlinie schneidet; und
5. auf einer Geraden, die durch die Punkte A und B verläuft, wird der Punkt C ermittelt, in dem die Gerade die Ausgleichsgeraden schneidet; und

wobei die Konturlinie sich von der Hauptbegrenzungsfläche der Metallschicht bis zur Hauptbegrenzungsfläche des Keramikkörpers erstreckt, wobei die Konturlinie eine obere Hälfte und eine untere Hälfte aufweist, wobei sich die obere Hälfte der Konturlinie von der Hauptbegrenzungsfläche der Metallschicht in Richtung der Hauptbegrenzungsfläche des Keramikkörpers erstreckt und sich die untere Hälfte der Konturlinie von der Hauptbegrenzungsfläche des Keramikkörpers in Richtung der Hauptbegrenzungsfläche der Metallschicht erstreckt, und wobei das feste Material in dem Bereich, der an der oberen Hälfte der Konturlinie anliegt, einen höheren Gehalt an Silber aufweist als in dem Bereich, der an der unteren Hälfte der Konturlinie anliegt.

Ferner betrifft die Erfindung ein elektronisches Bauteil aufweisend ein solches Metall-Keramik-Substrat.

Außerdem betrifft die Erfindung ein Verfahren zur Herstellung eines Metall-Keramik-Substrats.

Das erfindungsgemäße Metall-Keramik-Substrat umfasst einen Keramikkörper, der eine Hauptbegrenzungsfläche aufweist.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Als Hauptbegrenzungsfläche wird hierin vorzugsweise die Begrenzungsfläche (ganz besonders bevorzugt die Begrenzungsfläche mit dem größten Flächeninhalt) bezeichnet, die mit der Metallschicht flächig verbunden ist. Als Hauptbegrenzungsfläche wird besonders bevorzugt die Begrenzungsfläche (ganz besonders bevorzugt die Begrenzungsfläche mit dem größten Flächeninhalt) bezeichnet, die mit der Metallschicht, die einen Strukturierungsbereich aufweist, flächig verbunden ist und ganz besonders bevorzugt die Begrenzungsfläche (insbesondere die Begrenzungsfläche mit dem größten Flächeninhalt) bezeichnet, die mit der Metallschicht, auf der ein Kontaktbereich aufweisend Silber angeordnet ist, flächig verbunden ist. Die Hauptbegrenzungsfläche liegt vorzugsweise in der Haupterstreckungsebene des Keramikkörpers oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siluziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper weist vorzugsweise eine Dicke im Bereich von 0,05 - 10 mm, mehr bevorzugt eine Dicke im Bereich von 0,1 - 5 mm und besonders bevorzugt eine Dicke im Bereich von 0,15 - 3 mm auf.

Das erfindungsgemäße Metall-Keramik-Substrat umfasst eine Metallschicht, die eine Hauptbegrenzungsfläche aufweist, wobei die Metallschicht flächig mit dem Keramikkörper verbunden ist, und wobei die Metallschicht einen Strukturierungsbereich aufweist, der (i) bereichsweise festes Material und (ii) bereichsweise nicht-festes Material umfasst.

Die Metallschicht weist Begrenzungsflächen auf. Die Metallschicht weist eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die dem Keramikkörper abgewandt ist. Folglich wird als Hauptbegrenzungsfläche vorzugsweise die Begrenzungsfläche (ganz besonders bevorzugt die Begrenzungsfläche mit dem größten Flächeninhalt) bezeichnet, auf der der Kontaktbereich aufweisend Silber angeordnet ist. Die Hauptbegrenzungsfläche liegt vorzugsweise in der Haupterstreckungsebene der Metallschicht oder verläuft parallel zu dieser. Demnach wird unter Haupterstreckungsebene der Metallschicht vorzugsweise eine Ebene verstanden, die parallel zur Hauptbegrenzungsfläche der Metallschicht verläuft oder diese umschließt. Die Hauptbegrenzungsfläche der Metallschicht verläuft vorzugsweise parallel zur Hauptbegrenzungsfläche des Keramikkörpers und ist von dieser besonders bevorzugt beabstandet.

Die Metallschicht ist mit dem Keramikkörper vorzugsweise stoffschlüssig verbunden. Gemäß einer bevorzugten Ausführungsform ist die Metallschicht mit dem Keramikkörper über ein DCB (Direct Copper Bonding) -Verfahren verbunden. Gemäß einer weiteren bevorzugten Ausführungsform ist die Metallschicht mit dem Keramikkörper über ein Hartlotverfahren verbunden. Bei dem Hartlotverfahren kann es sich zum Beispiel um ein AMB (Active Metal Brazing) -Verfahren handeln, wobei vorzugsweise silberfreie Hartlote (der Gehalt an Silber beträgt dann zum Beispiel weniger als 1,0 Gewichtsprozent basierend auf dem Feststoffgehalt des Hartlotes) oder silberhaltige Hartlote (der Gehalt an Silber beträgt dann zum Beispiel wenigstens 50 Gewichtsprozent basierend auf dem Feststoffgehalt des Hartlotes) verwendet werden. Folglich kann die Metallschicht auch eine Verbindungsschicht umfassen, die mit dem Keramikkörper in Kontakt steht. Bei der Verbindungsschicht kann es sich zum Beispiel um eine Lotschicht (insbesondere eine Hartlotschicht) oder eine Diffusionsschicht handeln.

Die Metallschicht ist mit dem Keramikkörper flächig verbunden. Dementsprechend ist die Metallschicht flächig vorzugsweise mit der Hauptbegrenzungsfläche des Keramikkörpers verbunden. Die Metallschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Metallschicht. In diesen Fällen steht die Hauptbegrenzungsfläche des Keramikkörpers über. Darüber hinaus ist die Metallschicht vorzugsweise strukturiert. Unter Strukturierungen werden vorzugsweise Ausnehmungen in der Metallschicht verstanden, um einzelne Abschnitte der Metallschicht voneinander zu trennen und damit elektrisch zu isolieren. Derartige Strukturierungen werden üblicherweise durch Ätztechniken erzeugt.

Dementsprechend weist die Metallschicht einen Strukturierungsbereich auf. Unter Strukturierungsbereich wird ein Abschnitt der Metallschicht verstanden, der eine Strukturierung enthält. Bei einer Strukturierung handelt es sich vorzugsweise um eine Ausnehmung in der Metallschicht. Folglich umfasst die Hauptbegrenzungsfläche der Metallschicht Metall der Metallschicht, das im Strukturierungsbereich von der Ausnehmung unterbrochen ist.

Der Strukturierungsbereich weist einen Bereich, der festes Material umfasst, und einen Bereich, der nicht-festes Material umfasst, auf.

Der Bereich, der festes Material umfasst, enthält vorzugsweise (i) Metall der Metallschicht (gegebenenfalls einschließlich einer Verbindungsschicht (soweit vorhanden) und (ii) Metall des Kontaktbereichs (insbesondere Silber).

Der Bereich, der nicht-festes Material umfasst, enthält vorzugsweise gasförmiges Material. Daher umfasst das nicht-feste Material vorzugsweise gasförmiges Material. Das nicht-feste Material ist vorzugsweise gasförmiges Material, mit der die Ausnehmung in der Metallschicht befüllt ist. Dieses gasförmige Material stammt üblicherweise aus der Umgebungsatmosphäre. Vorzugsweise enthält das gasförmige Material daher wenigstens ein Element, das aus der Gruppe ausgewählt ist, die aus Stickstoff, Sauerstoff und Edelgasen besteht. Ganz bevorzugt handelt es sich bei dem gasförmigen Material um ein Gasgemisch, insbesondere Luft.

Gemäß einer bevorzugten Ausführungsform erstreckt sich die Ausnehmung in einer Richtung senkrecht zur Hauptbegrenzungsfläche des Keramikkörpers von der Hauptbegrenzungsfläche des Keramikkörpers bis zur Hauptbegrenzungsfläche der Metallschicht. Die Ausnehmung bildet dabei vorzugsweise einen Kanal aus, der zu wenigstens 50 Volumenprozent, mehr bevorzugt zu wenigstens 80 Volumenprozent, noch mehr bevorzugt zu wenigstens 90 Volumenprozent, besonders bevorzugt zu wenigstens 95 Volumenprozent und ganz besonders bevorzugt zu wenigstens 99 Volumenprozent, insbesondere vollständig, mit nicht-festem Material befüllt ist.

Die Metallschicht umfasst vorzugsweise wenigstens ein Metall, das aus der Gruppe ausgewählt, die aus Kupfer, Aluminium und Molybdän besteht. Gemäß einer besonders bevorzugten Ausführungsform umfasst die Metallschicht wenigstens ein Metall, das aus der Gruppe ausgewählt, die aus Kupfer und Molybdän besteht. Gemäß einer ganz besonders bevorzugten Ausführungsform umfasst die Metallschicht Kupfer. Gemäß einer weiteren bevorzugten Ausführungsform besteht die Metallschicht aus Kupfer und unvermeidlichen Verunreinigungen. Gemäß einer weiteren bevorzugten Ausführungsform beträgt der Anteil an Kupfer wenigstens 60 Gewichtsprozent, mehr bevorzugt wenigstens 65 Gewichtsprozent, noch mehr bevorzugt wenigstens 70 Gewichtsprozent und besonders bevorzugt wenigstens 75 Gewichtsprozent, bezogen auf das Gesamtgewicht der Metallschicht (vorzugsweise einschließlich einer gegebenenfalls enthaltenen Verbindungsschicht).

Gemäß einer bevorzugten Ausführungsform wird die Metallschicht erzeugt, indem eine Kupferfolie (vorzugsweise eine Folie aus hochreinem Kupfer) mit einem Keramikkörper stoffschlüssig verbunden wird. Gemäß einer bevorzugten Ausführungsform kann die Verbindung über ein DCB (Direct Copper Bonding) -Verfahren oder über ein Hartlotverfahren erfolgen. Bei dem Hartlotverfahren kann es sich zum Beispiel um ein AMB (Active Metal Brazing) -Verfahren handeln, wobei vorzugsweise silberfreie Hartlote (der Gehalt an Silber beträgt dann zum Beispiel weniger als 1,0 Gewichtsprozent basierend auf dem Feststoffgehalt des Hartlotes) oder silberhaltige Hartlote (der Gehalt an Silber beträgt dann zum Beispiel wenigstens 50 Gewichtsprozent basierend auf dem Feststoffgehalt des Hartlotes) verwendet werden. In diesem Fall kann die Metallschicht neben dem aus der Kupferfolie stammenden Kupfer auch Metalle einer Verbindungsschicht umfassen, insbesondere Metalle einer Lotschicht (zum Beispiel einer Hartlotschicht) oder einer Diffusionsschicht.

Die Metallschicht weist vorzugsweise eine Dicke im Bereich von 0,01 - 10 mm, besonders bevorzugt eine Dicke im Bereich von 0,03 - 5 mm und ganz besonders bevorzugt eine Dicke im Bereich von 0,05 - 3 mm auf.

Das erfindungsgemäße Metall-Keramik-Substrat weist einen auf der Metallschicht angeordneten Kontaktbereich aufweisend Silber auf. Der Kontaktbereich dient vorzugsweise dazu, die Anbindung eines Chips auf der Metallschicht zu erleichtern. Chips werden vorzugsweise durch Sintern, Löten oder Kleben mit der Metallschicht verbunden. Da insbesondere das Befestigen von Chips auf dem Metall der Metallschicht eines Metall-Keramik-Substrats nicht ohne weiteres möglich ist, wird die Metallschicht vorzugsweise mit einem Kontaktbereich versehen. Der Kontaktbereich besteht vorzugsweise aus Silber oder einer silberhaltigen Legierung. Im Fall einer silberhaltigen Legierung enthält diese wenigstens 50 Gewichtsprozent Silber, bezogen auf das Gewicht der Silberlegierung. Vorzugsweise ist ein Kontaktbereich auf der Metallschicht des Metall-Keramik-Substrats an allen Positionen vorgesehen, wo später eine Bestückung des Metall-Keramik-Substrats mit Chips erfolgen soll. Der Kontaktbereich kann auf der Metallschicht des Metall-Keramik-Substrats durch unterschiedliche Techniken ausgebildet sein. Beispielsweise ist es möglich, den Kontaktbereich durch Abscheidung einer silberhaltigen Schicht vorzusehen. Die Abscheidung der silberhaltigen Schicht erfolgt vorzugsweise chemisch (zum Beispiel elektrochemisch) oder physikalisch. Die chemische Abscheidung der silberhaltigen Schicht kann zum Beispiel galvanisch oder stromlos erfolgen. Vorzugsweise erfolgt die chemische Abscheidung der silberhaltigen Schicht stromlos durch Aufbringen einer silberhaltigen Lösung unter einem Ladungsaustausch zwischen den Metallen, wobei Metall der Metallschicht teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer besonders bevorzugten Ausführungsform handelt es sich bei der silberhaltigen Lösung um eine saure Lösung von Silbernitrat und besonders bevorzugt um eine salpetersaure Lösung von Silbernitrat. Die physikalische Abscheidung der silberhaltigen Schicht kann zum Beispiel durch Gasphasenabscheidung erfolgen. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben.

Der Strukturierungsbereich der Metallschicht des Metall-Keramik-Substrats weist die hierin beschriebene Geometrie auf. Die Geometrie des Strukturierungsbereichs wird in einem Querschnitt durch das Metall-Keramik-Substrat senkrecht zur Hauptbegrenzungsfläche des Keramikkörpers bestimmt.

Der Strukturierungsbereich der Metallschicht weist in einem Querschnitt durch das Metall-Keramik-Substrat senkrecht zur Hauptbegrenzungsfläche des Keramikkörpers eine Geometrie auf, wobei folgendes Erfordernis erfüllt ist:

$$S\ (BC_{solid})\ /\ S\ (BC_{total}) > 60\%,$$

wobei:

$S\ (BC_{total})$ für die gesamte Länge der Strecke zwischen den Punkten B und C steht und

S ($BC_{solid}$) für die Länge der Strecke zwischen den Punkten B und C steht, die festes Material schneidet.

Gemäß einer bevorzugten Ausführungsform weist der Strukturierungsbereich der Metallschicht in einem Querschnitt durch das Metall-Keramik-Substrat senkrecht zur Hauptbegrenzungsfläche des Keramikkörpers eine Geometrie auf, wobei das Verhältnis S ($BC_{solid}$) / S ($BC_{total}$) > 70% ist, mehr bevorzugt > 80% ist, noch mehr bevorzugt > 85% ist, besonders bevorzugt > 90% ist und ganz besonders bevorzugt > 95% ist.

Gemäß einer weiteren bevorzugten Ausführungsform weist der Strukturierungsbereich der Metallschicht in einem Querschnitt durch das Metall-Keramik-Substrat senkrecht zur Hauptbegrenzungsfläche des Keramikkörpers eine Geometrie auf, wobei das Verhältnis S ($BC_{solid}$) / S ($BC_{total}$) im Bereich von 70 - 100%, besonders bevorzugt im Bereich von 80 - 100% und ganz besonders bevorzugt im Bereich von 80 - 99%, liegt.

Zur Bestimmung der Punkte B und C wird ein Querschnitt des Strukturierungsbereichs der Metallschicht des Metall-Keramik-Substrats beobachtet. Der Querschnitt verläuft senkrecht zur Hauptbegrenzungsfläche des Keramikkörpers. Vorzugsweise kann die Beobachtung des Querschnitts erfolgen, indem das Metall-Keramik-Substrat senkrecht zur Hauptbegrenzungsfläche des Keramikkörpers geschnitten und eine Aufnahme des so erhaltenen Querschnitts durch ein Lichtmikroskop angefertigt wird.

Die Punkte B und C der Strecke BC können dabei im Querschnitt wie nachstehend beschrieben bestimmt werden.

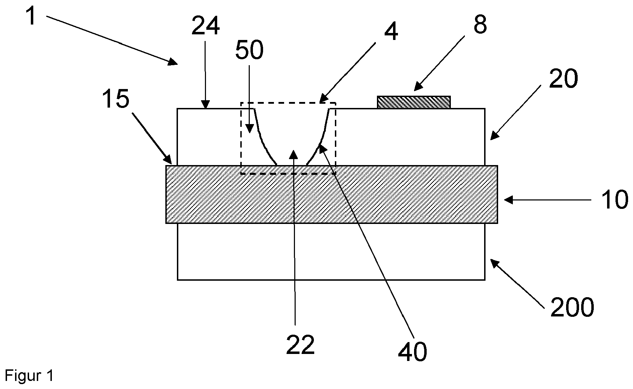

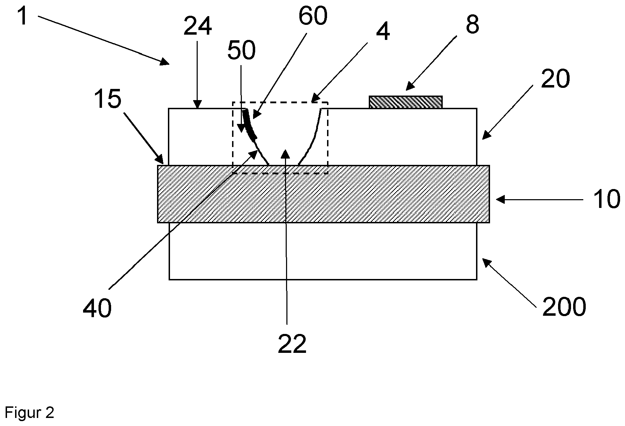

Zur Veranschaulichung wird beispielhaft auf die Figuren 1 und 2 Bezug genommen.

Figur 1 zeigt schematisch ein gattungsgemäßes Metall-Keramik-Substrat.

Figur 2 zeigt schematisch ein erfindungsgemäßes Metall-Keramik-Substrat mit einem Strukturierungsbereich, wobei das feste Material in dem Bereich, der an der oberen Hälfte der Konturlinie anliegt, einen höheren Gehalt an Silber aufweist als in dem Bereich, der an der unteren Hälfte der Konturlinie anliegt.

Figur 3 zeigt einen Teil eines Querschnitts durch ein erfindungsgemäßes Metall-Keramik-Substrat.

Das in Figur 1 gezeigte Metall-Keramik-Substrat 1 weist einen Keramikkörper 10 auf. Der Keramikkörper 10 weist eine Hauptbegrenzungsfläche 15 auf. Das Metall-Keramik-Substrat 1 weist eine Metallschicht 20 auf. Die Metallschicht 20 weist auf der Oberseite, die der Hauptbegrenzungsfläche 15 des Keramikkörpers 10 abgewandt ist, eine zur Hauptbegrenzungsfläche 15 des Keramikkörpers 10 parallele Hauptbegrenzungsfläche 24 auf. Die Metallschicht 20 ist flächig mit der Hauptbegrenzungsfläche 15 des Keramikkörpers 10 verbunden. Das Metall-Keramik-Substrat 1 weist in der Ausführungsform gemäß Figur 1 ferner eine weitere Metallschicht 200 auf, die flächig mit dem Keramikkörper 10 verbunden ist. Auf der Metallschicht 20 befindet sich ein Kontaktbereich 8 aufweisend Silber. Die Metallschicht 20 weist eine Strukturierung auf. Diese ist durch eine Ausnehmung 22 in der Metallschicht 20 gebildet. Die Ausnehmung 22 enthält nicht-festes Material. Der Strukturierungsbereich 4 umfasst bereichsweise das Metall der Metallschicht 20 und die Ausnehmung 22. Daher umfasst der Strukturierungsbereich 4 bereichsweise festes Material 50, das durch das Metall der Metallschicht 20 gebildet ist, und nicht-festes Material (zum Beispiel gasförmiges Material), mit der die Ausnehmung 22 befüllt ist. Das gasförmige Material ist üblicherweise Umgebungsluft. Das feste Material 50 ist vom nicht-festen Material der Ausnehmung 22 durch eine Konturlinie 40 getrennt. Die Hauptbegrenzungsfläche 24 der Metallschicht 20 umfasst Metall der Metallschicht 20, das im Strukturierungsbereich von der Ausnehmung 22 unterbrochen ist. Die Ausnehmung 22 erstreckt sich in einer Richtung senkrecht zur Hauptbegrenzungsfläche 15 des Keramikkörpers 10 von der Hauptbegrenzungsfläche 24 der Metallschicht 20 bis zur Hauptbegrenzungsfläche 15 des Keramikkörpers 10 und bildet dabei vorzugsweise einen Kanal aus, der vollständig oder überwiegend mit nicht festem-Material befüllt ist.

Das in Figur 2 gezeigte Metall-Keramik-Substrat weist denselben grundsätzlichen Aufbau auf wie das in Figur 1 gezeigte Metall-Keramik-Substrat. Die Konturlinie 40 weist eine obere Hälfte und eine untere Hälfte auf. Die obere Hälfte der Konturlinie 40 erstreckt sich von der Hauptbegrenzungsfläche 24 der Metallschicht 20 in Richtung der Hauptbegrenzungsfläche 15 des Keramikkörpers 10. Die untere Hälfte der Konturlinie 40 erstreckt sich von der Hauptbegrenzungsfläche 15 des Keramikkörpers 10 in Richtung der Hauptbegrenzungsfläche 24 der Metallschicht 20. Das feste Material 50 weist in dem Bereich, der an der oberen Hälfte der Konturlinie 40 anliegt, Silber 60 auf. In dem Bereich, der an der unteren Hälfte der Konturlinie 40 anliegt, weist das feste Material kein oder weniger Silber 60 auf.

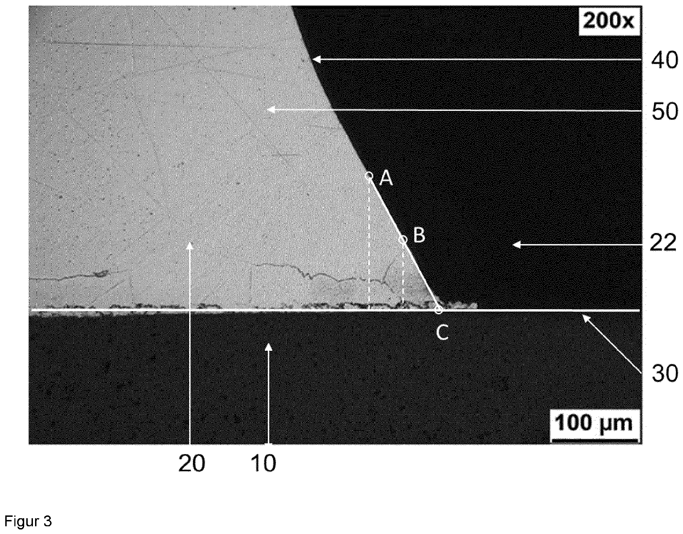

In dem Teil eines Querschnitts durch ein erfindungsgemäßes Metall-Keramik-Substrat, der in Figur 3 gezeigt ist, ist ein Abschnitt eines Strukturierungsbereichs zu sehen. Dargestellt sind ein Bereich des Keramikkörpers 10, der flächig mit einem Bereich einer Metallschicht 20 verbunden ist. Die Konturlinie 40 trennt das feste Material 50 vom nicht-festen Material der Ausnehmung 22 in der Metallschicht 20.

Die Bestimmung der Punkte B und C der Strecke BC im Querschnitt erfolgt vorzugsweise in mehreren Schritten: In einem ersten Schritt wird die Ausgleichsgerade 30 zwischen dem Keramikkörper 10 und der Metallschicht 20 bestimmt. Dazu wird optisch der Bereich des Keramikkörpers 10 und der Bereich der Metallschicht 20 ermittelt und die Ausgleichsgerade 30 als die im Querschnitt beobachtbare Grenze zwischen dem Keramikkörper 10 und der Metallschicht 20 festgelegt.

In einem zweiten Schritt wird die Konturlinie 40 bestimmt, die das feste Material 50 vom nicht-festen Material der Ausnehmung 22 trennt. Das feste Material 50 wird optisch bestimmt; dabei handelt es sich üblicherweise um das Material der Metallschicht 20. Das nicht-feste Material wird ebenfalls optisch bestimmt. Bei dem nicht-festen Material handelt es sich üblicherweise um gasförmiges Material, mit dem die Strukturierung als Ausnehmung 22 in der Metallschicht 20 befüllt ist.

In einem dritten Schritt wird auf einer Senkrechten zur Ausgleichsgeraden 30 im Abstand von 150 $\mu$m zur Ausgleichsgeraden 30 der Punkt A ermittelt, in dem die Senkrechte zur Ausgleichsgeraden 30 die Konturlinie 40 schneidet.

In einem vierten Schritt wird auf einer Senkrechten zur Ausgleichsgeraden 30 im Abstand von 80 $\mu$m zur Ausgleichsgeraden 30 der Punkt B ermittelt, in dem die Senkrechte zur Ausgleichsgeraden 30 die Konturlinie 40 schneidet.

In einem fünften Schritt wird auf einer Geraden, die durch die Punkte A und B verläuft, der Punkt C ermittelt, in dem die Gerade die Ausgleichsgerade 30 schneidet.

Der Schnitt des Metall-Keramik-Substrats senkrecht zur Hauptbegrenzungsfläche des Keramikkörpers und die Aufnahme des so erhaltenen Querschnitts durch ein Lichtmikroskop (Auflicht/Hellfeld) erfolgen vorzugsweise wie nachstehend beschrieben:

In einem ersten Schritt wird aus dem zu untersuchenden Metall-Keramik-Substrat zunächst durch Sägen mit einem Diamantsägeblatt bei niedriger Drehzahl und unter Verwendung eines Schmiermittels (Exakt) senkrecht zu einer durch die von der Hauptbegrenzungsfläche des Keramikkörpers des Metall-Keramik-Substrats aufgespannten Ebene ein quaderförmiger Probenrohling mit einer rechteckigen Grundfläche im Bereich von 100 mm$^2$ bis 400 mm$^2$ ausgeschnitten. Der Probenrohling weist demnach eine Probenoberfläche auf, die der Untersuchung zugeführt wird. Diese Probenoberfläche verläuft mithin senkrecht zu der vor dem Sägen durch die von der Hauptbegrenzungsfläche des Keramikkörpers des Metall-Keramik-Substrats aufgespannten Ebene. Sie weist daher Anteile an dem Keramikkörper und der Metallschicht (einschließlich der gegebenenfalls vorhandenen Verbindungsschicht) auf. Der Probenrohling wird zunächst in einer Gussform mit einem Epoxidharz mit geringer Schrumpfung (Caldo-Fix, Struers) eingebettet, wobei die Probenoberfläche senkrecht zur Formwand orientiert ist. Anschließend wird das Epoxidharz bei 75°C im Trockenschrank ausgehärtet. Nach der Aushärtung wird die Probenoberfläche des Probenrohlings mit einer automatisierten Poliervorrichtung (Tegrapol, Struers) mechanisch poliert, um eine Rauigkeit von 1 $\mu$m oder weniger zu erreichen.

In einem zweiten Schritt wird mittels Lichtmikroskop (Leica, DM6000M, Auflicht/Hellfeld) bei einer Vergrößerung von 200x in der Analysezone ein Strukturierungsbereich in der Metallschicht identifiziert, der bereichsweise festes Material und bereichsweise nicht-festes Material umfasst. Festes Material und nicht-festes Material können in dem Strukturierungsbereich aufgrund der unterschiedlichen Farbgebung eindeutig unterschieden werden.

Die Längen der Strecken S ($BC_{total}$) und S ($BC_{solid}$) werden vorzugsweise auf fachübliche Weise bestimmt, so zum Beispiel unter Verwendung einer Bildauswertungssoftware (zum Beispiel IMS Client, Imagic).

Vorzugsweise bezieht sich der Begriff "in einem Querschnitt", wie hierin verwendet, auf eine (vorzugsweise repräsentative) Gesamtheit von Querschnitten, besonders bevorzugt auf wenigstens zehn Querschnitte, ganz besonders bevorzugt auf nicht mehr als 20 Querschnitte und insbesondere zehn Querschnitte. Die Querschnitte verlaufen vorzugsweise parallel zueinander und sind gleichmäßig voneinander beabstandet.

Dabei wird zur Ermittlung des Verhältnisses S ($BC_{solid}$) / S ($BC_{total}$) für ein zu beobachtendes Metall-Keramik-Substrat vorzugsweise wie folgt vorgegangen:

1. Es werden wenigstens zehn, besonders bevorzugt zehn, unterschiedliche Querschnitte des Strukturierungsbereichs untersucht;
2. es wird das Verhältnis S ($BC_{solid}$) / S ($BC_{total}$) für jeden dieser Querschnitte bestimmt; und
3. es wird der Mittelwert aus den Verhältnissen S ($BC_{solid}$) / S ($BC_{total}$) für jeden dieser Querschnitte gebildet, um zum Verhältnis S ($BC_{solid}$) / S ($BC_{total}$) für das zu beobachtende Metall-Keramik-Substrat zu gelangen.

Gemäß einer bevorzugten Ausführungsform beträgt die Stichprobenstandardabweichung SSD des Verhältnisses S ($BC_{solid}$) / S ($BC_{total}$) über wenigstens zehn unterschiedliche Querschnitte des Strukturierungsbereichs der Metallschicht, mehr bevorzugt über nicht mehr als 20 unterschiedliche Querschnitte des Strukturierungsbereichs der Metallschicht, und ganz besonders bevorzugt über zehn unterschiedliche Querschnitte des Strukturierungsbereichs der Metallschicht, nicht mehr als 10%, mehr bevorzugt nicht mehr als 7%, besonders bevorzugt nicht mehr als 5% und ganz besonders bevorzugt nicht mehr als 3%. Die Stichprobenstandardabweichung SSD wird dabei nach folgender Formel ermittelt:

$$SSD = \sqrt{\frac{1}{n-1} \sum_{i=1}^{n} \left( X_i - \overline{X} \right)^2},$$

wobei:

$n$ = Anzahl der Einzelwerte für das Verhältnis S ($BC_{solid}$) / S ($BC_{total}$),

$X_i$ = Einzelwert für das Verhältnis S ($BC_{solid}$) / S ($BC_{total}$) und

$X$ = Mittelwert aus den Einzelwerten für das Verhältnis S ($BC_{solid}$) / S ($BC_{total}$).

Erfindungsgemäß weist in einem Querschnitt durch das Metall-Keramik-Substrat senkrecht zur Hauptbegrenzungsfläche des Keramikkörpers der Strukturierungsbereich eine Geometrie auf, wobei die Konturlinie sich von der Hauptbegrenzungsfläche der Metallschicht bis zur Hauptbegrenzungsfläche des Keramikkörpers erstreckt, wobei die Konturlinie eine obere Hälfte und eine untere Hälfte aufweist, wobei sich die obere Hälfte der Konturlinie von der Hauptbegrenzungsfläche der Metallschicht in Richtung der Hauptbegrenzungsfläche des Keramikkörpers erstreckt und sich die untere Hälfte der Konturlinie von der Hauptbegrenzungsfläche des Keramikkörpers in Richtung der Hauptbegrenzungsfläche der Metallschicht erstreckt, und wobei das feste Material in dem Bereich, der an der oberen Hälfte der Konturlinie anliegt, einen höheren Gehalt an Silber aufweist als in dem Bereich, der an der unteren Hälfte der Konturlinie anliegt.

Erfindungsgemäß erstreckt sich die Konturlinie daher von der Hauptbegrenzungsfläche der Metallschicht bis zur Hauptbegrenzungsfläche des Keramikkörpers. Die Konturlinie erstreckt sich vorzugsweise nicht entlang der Hauptbegrenzungsfläche der Keramik und nicht entlang der Hauptbegrenzungsfläche der Metallschicht. Daher erstreckt sich die Konturlinie vorzugsweise über einen Bereich, der die Hauptbegrenzungsfläche der Keramik und die Hauptbegrenzungsfläche der Metallschicht nicht mitumfasst.

Die Konturlinie weist eine obere Hälfte und eine untere Hälfte auf. Die obere Hälfte der Konturlinie erstreckt sich von der Hauptbegrenzungsfläche der Metallschicht in Richtung der Hauptbegrenzungsfläche des Keramikkörpers. Die untere Hälfte der Konturlinie erstreckt sich von der Hauptbegrenzungsfläche der Keramik in Richtung der Hauptbegrenzungsfläche der Metallschicht.

Erfindungsgemäß weist das feste Material in dem Bereich, der an der oberen Hälfte der Konturlinie anliegt, einen höheren Gehalt an Silber auf als in dem Bereich, der an der unteren Hälfte der Konturlinie anliegt. Gemäß einer bevorzugten Ausführungsform liegt das Verhältnis des Gehalts an Silber im festen Material in dem Bereich, der an der unteren Hälfte der Konturlinie anliegt, zum Gehalt an Silber im festen Material in dem Bereich, der an der oberen Hälfte der Konturlinie anliegt, bei weniger als 0,8, mehr bevorzugt bei weniger als 0,5, noch mehr bevorzugt bei weniger als 0,3, besonders bevorzugt bei weniger als 0,1 und ganz besonders bevorzugt bei weniger als 0,05.

Der Bereich des festen Materials, der an der Konturlinie anliegt, weist vorzugsweise eine Breite im Bereich von 0,3 - 1,0 $\mu$m, besonders bevorzugt eine Breite im Bereich von 0,5 - 0,6 $\mu$m und ganz besonders bevorzugt eine Breite von 0,5 $\mu$m auf. Die Konturlinie beschreibt damit vorzugsweise den Umriss des festen Materials, wobei die Zusammensetzung des festen Materials (einschließlich des Gehalts an Silber) mit der vorstehend beschriebenen Methode vorzugsweise in einem Bereich bestimmt wird, der begrenzt ist durch (i) die Hauptbegrenzungsfläche der Metallschicht, (ii) die Hauptbegrenzungsfläche des Keramikkörpers, (iii) die Konturlinie und (iv) eine Parallelverschiebung der Konturlinie in Richtung des festen Materials um 0,3 - 1,0 $\mu$m, besonders bevorzugt um 0,5 - 0,6 $\mu$m und ganz besonders bevorzugt um 0,5 $\mu$m. Die Konturlinie wird vorzugsweise auf halber Streckenlänge zwischen der Hauptbegrenzungsfläche der Metallschicht und der Hauptbegrenzungsfläche des Keramikkörpers in eine obere Hälfte und eine untere Hälfte unterteilt, wobei sich die obere Hälfte der Konturlinie von der Hauptbegrenzungsfläche der Metallschicht in Richtung der Hauptbegrenzungsfläche des Keramikkörpers erstreckt und sich die untere Hälfte der Konturlinie von der Hauptbegrenzungsfläche des Keramikkörpers in Richtung der Hauptbegrenzungsfläche der Metallschicht erstreckt. Der zu vermessende Bereich an festem Material besteht dementsprechend aus einer oberen Hälfte, der an der oberen Hälfte der Konturlinie anliegt, und einer unteren Hälfte, der an der unteren Hälfte der Konturlinie anliegt.

Der Gehalt an Silber, den das feste Material in dem Bereich, der an der oberen Hälfte der Konturlinie anliegt, aufweist, und der Gehalt an Silber, den das feste Material in dem Bereich, der an der unteren Hälfte der Konturlinie anliegt, aufweist, werden vorzugsweise durch eine energiedispersive Röntgenspektroskopie (EDX), gekoppelt mit Rasterelektronenmikroskopie (REM), bestimmt (REM-EDX).

Bei REM-EDX wird ein fokussierter Primär-Elektronenstrahl punktweise über die Probenoberfläche geführt (gerastert). Die gestreuten Elektronen werden mit einem Detektor erfasst, wobei die Elektronenzahl pro Bildpunkt ein mikroskopisches Abbild der Probenoberfläche in Graustufen ergibt. Zusätzlich regt der Primär-Elektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden können.

Für die Untersuchung wird beispielsweise ein Raster-Elektronenmikroskop (JSM-6060 SEM, JEOL Ltd) mit einem Silizium Drift EDX Detektor (NORAN, Thermo Scientific Inc) und einer Analysesoftware (Pathfinder Mountaineer EDS System, zum Beispiel Version 2.8, Thermo Scientific Inc) verwendet. Für die Raster-Elektronenmikroskopie können folgende Einstellungen verwendet werden: Vergrößerung: 200fach, Beschleunigungsspannung = 10 kV, Arbeitsabstand = 10 mm, Spotgröße (50 - 60) (eingestellt, um 25% +/- 5% der Totzeit des EDX-Detektors zu erreichen). Das EDX-Spektrum kann unter Verwendung der folgenden Einstellungen des EDX-Detektors erfasst werden: Live Time = 30 s, Rate = auto, Low Energy Cutoff = 100 keV, High Energy Cutoff = Auto (per REM-Beschleunigungsspannung). Je nach der gewählten Vergrößerung und der Dicke der Metallschicht sind gegebenenfalls mehrere REM-EDX-Messungen erforderlich, um den gesamten Strukturierungsbereich abbilden zu können.

Die Messung des Silbergehalts erfolgt in dem Bereich, der an der oberen Hälfte der Konturlinie anliegt, und in dem Bereich, der an der unteren Hälfte der Konturlinie anliegt, an jeweils wenigstens fünf und besonders bevorzugt an zehn repräsentativen Positionen innerhalb des jeweiligen Bereichs. Unter dem Silbergehalt ist vorzugsweise der arithmetische Mittelwert aus den jeweiligen Einzelmessungen zu verstehen.

Überraschenderweise wurde festgestellt, dass Metall-Keramik-Substrate mit der erfindungsgemäßen Geometrie eine erhöhte Temperaturwechselbeständigkeit gegenüber Metall-Keramik-Substraten aus dem Stand der Technik aufweisen. Diese Metall-Keramik-Substrate weisen in der Metallschicht an der Grenze zur Oberfläche des Keramikkörpers einen hohen Anteil an festem Material auf. Im Gegensatz dazu wurde festgestellt, dass der Anteil an festem Material in der Metallschicht an der Grenze zur Oberfläche des Keramikkörpers bei Metall-Keramik-Substraten aus dem Stand der Technik, soweit diese einen auf der Metallschicht angeordneten Kontaktbereich aufweisend Silber aufweisen, deutlich geringer ist.

Ohne an eine Erklärung gebunden zu sein, könnte dies darauf zurückzuführen sein, dass im Stand der Technik das hergestellte Metall-Keramik-Substrat üblicherweise zunächst strukturiert und im Anschluss zur Schaffung des Kontaktbereichs oberflächlich versilbert wird, wobei jedoch bei der Versilberung die bereits strukturierten Bereiche der Oberfläche des Metall-Keramik-Substrats nur unzureichend maskiert sind. Hierzu werden vor der Versilberung in der Regel zunächst die Bereiche der Oberfläche des strukturierten Metall-Keramik-Substrats maskiert, die nicht mit Silber beschichtet werden sollen. Dabei wird für die Maskierung üblicherweise eine Folie (zum Beispiel ein Trockenfilm) verwendet. Diese Folie überspannt die Strukturierungen des Metall-Keramik-Substrats, so dass die Strukturierungen mit der Folie zwar abgedeckt, nicht aber vollständig ausgekleidet sind, insbesondere nicht in einem Bereich in der Nähe des Keramikkörpers. Die anschließende Versilberung erfolgt üblicherweise dadurch, dass das strukturierte und maskierte Metall-Keramik-Substrat in ein Bad mit einer silberionenhaltigen Lösung getaucht wird. Dabei kann die silberionenhaltige Lösung die Maskierungsfolie unterspülen, so dass diese direkt mit der darunterliegenden Strukturierung in Kontakt kommt. Bei dem Prozess der Versilberung werden elektrochemisch Metallionen aus der Metallschicht des Metall-Keramik-Substrats im Bereich der Strukturierung herausgelöst und durch Silberionen ersetzt. Dabei hat sich gezeigt, dass das Herauslösen der Metallionen aus der Metallschicht und das Abscheiden von Silberionen in räumlich voneinander beabstandeten Bereichen in der Nähe des Keramikkörpers erfolgen. Daher erfolgt die Abscheidung von Silber häufig unmittelbar an der Oberfläche der Strukturierung, während sich die Metallionen bevorzugt aus einem zum Keramikkörper nahen Bereich (ca. bis zu 50 $\mu$m Abstand zur Keramikkörperoberfläche) herauslösen, so dass der dem Keramikkörper nahe Bereich der Strukturierung mit fortschreitender Kontaktzeit mit der silberionenhaltigen Lösung allmählich abgetragen wird. Dadurch kommt es zu einer Abtragung von festem Material - insbesondere des Metalls der Metallfolie - aus der Metallfolie im Bereich nahe des Keramikkörpers und somit zur Schaffung einer Schwachstelle für die Ablösung der Metallschicht vom Keramikkörper, was sich nachteilig auf die Temperaturwechselbeständigkeit auswirkt. Die Abtragung von festem Material in der Strukturierung könnte daher auf eine fehlende Auskleidung der Strukturierung mit der Maskierungsfolie zurückzuführen sein. Erfindungsgemäß wird dagegen ein Strukturierungsbereich geschaffen, der ausreichende Mengen von festem Material im Bereich nahe des Keramikkörpers aufweist, wodurch eine Ablösung der Metallschicht vom Keramikkörper verhindert und eine Verbesserung der Temperaturwechselbeständigkeit erreicht werden kann.

Das feste Material weist in dem Bereich, der an der oberen Hälfte der Konturlinie anliegt, Silber auf. Die Ursache hierfür ist, dass die Maskierung vor der Versilberung gemäß einer Ausführungsform durch ein Druckverfahren aufgebracht wird. Da die Strukturierung des Metall-Keramik-Substrats üblicherweise eine gewölbte Geometrie aufweist, erfolgt hierbei eine (nahezu) vollständige Abdeckung der Strukturierung mit der Maskierung in einem Bereich nahe des Keramikkörpers, was eine Verbesserung der Temperaturwechselbeständigkeit bewirkt. Ein vom Keramikkörper weiter beabstandeter Bereich der Strukturierung ist dagegen üblicherweise nicht vollständig maskiert, so dass dieser im anschließenden Versilberungsschritt mit Silber zumindest teilweise beschichtet wird.

Gemäß einer bevorzugten Ausführungsform umfasst das Metall-Keramik-Substrat eine weitere (zweite) Metallschicht, die flächig mit dem Keramikkörper verbunden ist. Die weitere Metallschicht ist vorzugsweise mit der der Hauptbegrenzungsfläche der Keramik abgewandten (und vorzugsweise zu dieser parallel verlaufenden) Begrenzungsfläche flächig verbunden. Die weitere (zweite) Metallschicht kann wie die (erste) Metallschicht beschaffen sein oder in ihrer Beschaffenheit von der (ersten) Metallschicht abweichen. Zur Beschaffenheit der weiteren (zweiten) Metallschicht wird auf die vorstehenden Erläuterungen zur (ersten) Metallschicht Bezug genommen.

Das erfindungsgemäße Metall-Keramik-Substrat kann insbesondere für Anwendungen in der Elektronik, vor allem für den Bereich der Leistungselektronik, eingesetzt werden.

Die Erfindung stellt daher auch ein elektronisches Bauteil bereit, das das erfindungsgemäße Metall-Keramik-Substrat aufweist.

Gemäß einer bevorzugten Ausführungsform umfasst das elektronische Bauteil das erfindungsgemäße Metall-Keramik-Substrat und wenigstens einen Chip. Der wenigstens eine Chip ist vorzugsweise flächig mit dem auf der (ersten) Metallschicht angeordneten Kontaktbereich aufweisend Silber verbunden. Daher umfasst das elektronische Bauteil vorzugsweise einen Chip, der mit der (ersten) Metallschicht des Metall-Keramik-Substrats über den Kontaktbereich aufweisend Silber in Kontakt steht.

Gemäß einer weiteren bevorzugten Ausführungsform umfasst das Metall-Keramik-Substrat des elektronischen Bauteils eine weitere (zweite) Metallschicht. Die weitere (zweite) Metallschicht ist vorzugsweise flächig mit dem Keramikkörper verbunden. Dabei ist die weitere Metallschicht vorzugsweise mit der der Hauptbegrenzungsfläche des Keramikkörpers abgewandten (und vorzugsweise zu dieser parallel verlaufenden) Begrenzungsfläche des Keramikkörpers flächig verbunden.

Gemäß einer weiteren bevorzugten Ausführungsform umfasst das elektronische Bauteil eine Bodenplatte. Diese Bodenplatte ist vorzugsweise mit der weiteren (zweiten) Metallschicht des Metall-Keramik-Substrats flächig verbunden. Alternativ kann die weitere (zweite) Metallschicht des Metall-Keramik-Substrats als Kühlkörper ausgebildet sein.

Gemäß einer weiteren bevorzugten Ausführungsform umfasst das elektronische Bauteil ein Metall-Keramik-Substrat, das eine (erste) Metallschicht und eine weitere (zweite) Metallschicht aufweist (wobei die weitere Metallschicht vorzugsweise mit der der Hauptbegrenzungsfläche des Keramikkörpers abgewandten Begrenzungsfläche flächig verbunden ist), eine Bodenplatte und wenigstens einen Chip, wobei der wenigstens eine Chip mit der ersten Metallschicht des Metall-Keramik-Substrats über den auf der Metallschicht angeordneten Kontaktbereich aufweisend Silber und die Bodenplatte mit der weiteren (zweiten) Metallschicht des Metall-Keramik-Substrats flächig verbunden sind.

Das erfindungsgemäße Metall-Keramik-Substrat kann durch unterschiedliche Herstellverfahren erhalten werden.

Die Erfindung stellt auch ein Verfahren zur Herstellung eines Metall-Keramik-Substrats, das mit einer Strukturierung und einem Kontaktbereich aufweisend Silber versehen ist, bereit.

Das Verfahren zur Herstellung eines Metall-Keramik-Substrats, das mit einer Strukturierung und einem Kontaktbereich aufweisend Silber versehen ist, umfasst die Schritte:

   a) Bereitstellung eines Metall-Keramik-Substrats aufweisend

      a1) einen Keramikkörper und
      a2) eine mit dem Keramikkörper flächig verbundene Metallschicht,

   b) Strukturieren der Metallschicht,
   c) Aufbringen einer Maskierung auf die strukturierte Metallschicht, indem ein flüssiges Medium, das ein Maskierungsmittel umfasst, bereichsweises auf die strukturierte Metallschicht aufgetragen und das Maskierungsmittel verfestigt wird,
   d) Abscheiden einer silberhaltigen Schicht auf die unmaskierten Bereiche der strukturierten Metallschicht unter Erhalt eines Kontaktbereichs aufweisend Silber, und
   e) Entfernen der Maskierung.

In Schritt a) wird zunächst ein Metall-Keramik-Substrat bereitgestellt.

Dieses Metall-Keramik-Substrat weist einen Keramikkörper und eine mit dem Keramikkörper flächig verbundene Metallschicht auf. Bei dem Metall-Keramik-Substrat kann es sich um ein fachübliches Metall-Keramik-Substrat handeln. Der Keramikkörper und die Metallschicht können eine Zusammensetzung aufweisen, wie sie vorstehend in Bezug auf das Metall-Keramik-Substrat beschrieben ist. Die Metallschicht kann mit dem Keramikkörper vorzugsweise stoffschlüssig verbunden sein, wie dies ebenfalls vorstehend in Bezug auf das Metall-Keramik-Substrat beschrieben ist.

In Schritt b) wird die Metallschicht strukturiert.

Unter Strukturierungen werden vorzugsweise Ausnehmungen in der Metallschicht verstanden, um einzelne Abschnitte der Metallschicht voneinander zu trennen und damit elektrisch zu isolieren. Die Strukturierungen legen daher vorzugsweise Bereiche des Keramikkörpers frei. Derartige Strukturierungen werden üblicherweise durch Ätztechniken erzeugt. Hierzu kann zum Beispiel auf die Metallschicht zunächst eine Ätzmaske aufgebracht werden. Die Ätzmaske dient dazu, die maskierten Bereiche der Metallschicht in einem Ätzschritt vor dem Ätzen zu schützen. Dies stellt sicher, dass nur solche Bereiche der Metallschicht des Metall-Keramik-Substrats für das Ätzen zugänglich sind, die unmaskiert und für eine Strukturierung vorgesehen sind. Folglich ist die Ätzmaske so beschaffen, dass im Ätzschritt kein Ätzen der maskierten Bereiche der Metallschicht erfolgt. Die Art der Ätzmaske ist nicht weiter eingeschränkt. Bei der Ätzmaske kann es sich beispielsweise um eine fachübliche Negativmaske oder Positivmaske handeln. Für die Erzeugung der Ätzmaske können fachübliche Ätzresists zum Einsatz kommen. Diese Ätzresists enthalten vorzugsweise ein härtbares Polymer (zum Beispiel ein lichthärtbares Polymer) und können zum Beispiel als Folie (zum Beispiel als Trockenfilm) oder als Flüssigkeit (zum Beispiel durch Drucken oder Sprühen) auf die Metallschicht aufgebracht werden. Nach dem Aufbringen können die Ätzresists auf eine geeignete Weise behandelt (zum Beispiel durch Lichteinstrahlung gehärtet) werden, um die Ätzmaske zu erhalten. Gemäß einer möglichen Ausführungsform wird auf die Metallschicht des Metall-Keramik-Substrats eine photosensitive Folie aufgebracht, die anschließend an den zu maskierenden Bereichen belichtet wird, um die Ätzmaske zu erhalten. Die unbelichteten Bereiche der photosensitiven Folie können im Anschluss auf fachübliche Weise entfernt werden (zum Beispiel unter Einsatz einer Natriumcarbonatlösung).

Nach dem Aufbringen der Ätzmaske auf die Metallschicht erfolgt vorzugsweise das Ätzen von unmaskierten Bereichen der Metallschicht unter Erhalt einer Strukturierung. Das Ätzen erfolgt vorzugsweise auf fachübliche Weise. Vorzugsweise erfolgt das Ätzen daher mit einer fachüblichen Ätzlösung. Gemäß einer bevorzugten Ausführungsform ist die Ätzlösung aus der Gruppe ausgewählt, die aus $FeCl_3$-Ätzlösungen und $CuCl_2$-Ätzlösungen besteht. Falls erforderlich, kann eine weitere Ätzlösung verwendet werden, zum Beispiel um unmaskierte Bereiche einer optional enthaltenen Verbindungsschicht zu strukturieren. Gemäß einer bevorzugten Ausführungsform kann die weitere Ätzlösung aus der Gruppe ausgewählt sein, die aus Ätzlösungen enthaltend Wasserstoffperoxid und aus Ätzlösungen enthaltend Ammoniumperoxodisulfat besteht. Zum Beispiel kann die weitere Ätzlösung eine Ätzlösung sein, die Ammoniumfluorid und Fluorborsäure (zum Beispiel $HBF_4$) sowie Wasserstoffperoxid und/oder Ammoniumperoxodisulfat enthält.

Vorzugsweise erfolgt nach dem Ätzen von unmaskierten Bereichen der Metallschicht unter Erhalt einer Strukturierung das Entfernen der Ätzmaske. Die Ätzmaske kann auf eine fachübliche Weise entfernt werden. Hierzu kann das Metall-Keramik-Substrat beispielsweise mit einer alkalischen Lösung (zum Beispiel einer 2,5%igen Natriumhydroxidlösung) behandelt werden, um die Ätzmaske zu entfernen.

In Schritt c) wird eine Maskierung auf die strukturierte Metallschicht aufgebracht, indem ein flüssiges Medium, das ein Maskierungsmittel umfasst, bereichsweise auf die strukturierte Metallschicht aufgetragen und das Maskierungsmittel verfestigt wird.

Die Maskierung dient dazu, die maskierten Bereiche der Metallschicht in Schritt d) vor einer Abscheidung einer silberhaltigen Schicht zu schützen. Dies stellt sicher, dass eine Abscheidung einer silberhaltigen Schicht nur auf die unmaskierten Bereiche der Metallschicht des Metall-Keramik-Substrats erfolgt. Folglich ist die Maskierung so beschaffen, dass kein Abscheiden einer silberhaltigen Schicht auf die maskierten Bereiche der Metallschicht des Metall-Keramik-Substrats erfolgen kann.

Gemäß einer bevorzugten Ausführungsform umfasst die strukturierte Metallschicht, auf die die Maskierung aufgebracht wird, auch den Strukturierungsbereich, besonders bevorzugt den Strukturierungsbereich zwischen der Hauptbegrenzungsfläche der Metallschicht und der Hauptbegrenzungsfläche der Keramik. Somit werden insbesondere auch die Bereiche der Metallschicht in der Nähe des Keramikkörpers mit einer Maskierung ausgestattet, um diese vor einer Auflösung bei der Abscheidung einer silberhaltigen Schicht, insbesondere bei Kontakt mit der silberionenhaltigen Lösung, in Schritt d) zu schützen.

Zum Aufbringen der Maskierung wird ein flüssiges Medium, das ein Maskierungsmittel umfasst, bereichsweise auf die strukturierte Metallschicht aufgetragen und das Maskierungsmittel verfestigt.

Das flüssige Medium ist vorzugsweise ein Medium, dass bei Raumtemperatur und Normaldruck flüssig ist. Das flüssige Medium ist vorzugsweise ein Medium, das ein polares Lösungsmittel, besonders bevorzugt Wasser, umfasst. Gemäß einer bevorzugten Ausführungsform ist das flüssige Medium aus der Gruppe ausgewählt, die aus Lösungen und Suspensionen besteht.

Das flüssige Medium umfasst ein Maskierungsmittel. Das Maskierungsmittel ist vorzugsweise so beschaffen, dass es verfestigbar ist. Dabei ist das Maskierungsmittel nicht weiter eingeschränkt. Gemäß einer bevorzugten Ausführungsform ist das Maskierungsmittel härtbar, insbesondere UV-härtbar. Das UV-härtbare Maskierungsmittel umfasst vorzugsweise wenigstens eine Verbindung, die aus der Gruppe ausgewählt ist, die aus Monomeren und Oligomeren besteht. Gemäß einer besonders bevorzugten Ausführungsform umfasst das UV-härtbare Maskierungsmittel wenigstens eine Verbindung, die aus der Gruppe ausgewählt ist, die aus Acrylaten, Epoxiden und ungesättigten Polyesterharzen besteht. Das flüssige Medium umfasst vorzugsweise ferner einen Photoinitiator. Der Photoinitiator kann beispielsweise eine Verbindung sein, die nach Absorption von UV-Licht zerfällt und eine reaktive Spezies bildet, die in der Lage ist, die Polymerisation und Aushärtung des UV-härtbaren Maskierungsmittels zu starten. Darüber hinaus kann das flüssige Medium weitere Bestandteile umfassen, wie zum Beispiel Farbmittel und Additive.

Das flüssige Medium, das ein Maskierungsmittel umfasst, wird bereichsweise auf die strukturierte Metallschicht aufgetragen. Hierzu wird das flüssige Medium vorzugsweise auf die Bereiche der strukturierten Metallschicht aufgetragen, die maskiert und vor dem Abscheiden einer silberhaltigen Schicht in Schritt d) geschützt werden sollen.

Die Auftragung des flüssigen Mediums auf die strukturierte Metallschicht erfolgt vorzugsweise durch Drucken, Sprühen oder Streichen. Gemäß einer besonders bevorzugten Ausführungsform erfolgt die Auftragung des flüssigen Mediums durch Drucken mit einem Inkjetverfahren.

Nach dem Auftragen des flüssigen Mediums wird das darin enthaltene Maskierungsmittel vorzugsweise verfestigt. Hierzu wird das Maskierungsmittel vorzugsweise ausgehärtet. Die Aushärtung kann zum Beispiel dadurch erreicht werden, dass das flüssige Medium mit UV-Licht bestrahlt wird, so dass die im flüssigen Medium enthaltenen Maskierungsmittel (insbesondere Monomere oder Oligomere) polymerisieren.

Gemäß einer bevorzugten Ausführungsform umfasst das Aufbringen der Maskierung auf die strukturierte Metallschicht einen additiven Maskierungsschritt. Unter additivem Maskierungsschritt wird das Aufbringen eines Maskierungsmittels verstanden. Gemäß einer weiteren bevorzugten Ausführungsformen umfasst das Aufbringen der Maskierung auf die strukturierte Metallschicht nicht einen subtraktiven Maskierungsschritt. Unter subtraktivem Maskierungsschritt wird das teilweise Entfernen von - zum Beispiel in einem additiven Maskierungsschritt aufgebrachtem und - verfestigtem Maskierungsmittel, insbesondere vor dem Abscheiden einer silberhaltigen Schicht auf den unmaskierten Bereichen der strukturierten Metallschicht unter Erhalt eines Kontaktbereichs aufweisend Silber gemäß Schritt d), verstanden. Gemäß dieser bevorzugten Ausführungsform wird das flüssige Medium, das das Maskierungsmittel umfasst, nur auf die Bereiche der strukturierten Metallschicht und gegebenenfalls Bereiche des Keramikkörpers, die durch die die Strukturierung bildenden Ausnehmungen in der Metallschicht freigelegt sind, aufgetragen, auf die in Schritt d) keine silberhaltige Schicht abgeschieden wird. Bei herkömmlichen Maskierungsverfahren wird in einem additiven Maskierungsschritt Maskierungsmittel auf die strukturierte Metallschicht, vorzugsweise als Schicht, insbesondere vollflächig, aufgebracht, wobei in einem anschließenden subtraktiven Maskierungsschritt das verfestigte Maskierungsmittel in den Bereichen der strukturierten Metallschicht entfernt wird, auf die in einem anschließenden Schritt eine silberhaltige Schicht abgeschieden wird. Durch das Weglassen eines subtraktiven Maskierungsschrittes wird gemäß dieser bevorzugten Ausführungsform in vorteilhafter Weise ein besonders einfaches Verfahren zur Herstellung eines Metall-Keramik-Substrats, das mit einer Strukturierung und einem Kontaktbereich aufweisend Silber versehen ist, bereitgestellt.

Gemäß einer bevorzugten Ausführungsform erfolgt in Schritt c) auch das Aufbringen einer Maskierung auf Bereiche des Keramikkörpers, die durch die die Strukturierung bildenden Ausnehmungen in der Metallschicht freigelegt sind, indem ein flüssiges Medium, das ein Maskierungsmittel umfasst, auf Bereiche des Keramikkörpers, die durch die die Strukturierung bildenden Ausnehmungen in der Metallschicht freigelegt sind, aufgetragen und das Maskierungsmittel verfestigt wird. Das Aufbringen einer Maskierung auf freiliegende Bereiche des Keramikkörpers kann vorteilhaft sein, um die freiliegenden Bereiche des Keramikkörpers in Schritt d) vor einer Abscheidung einer silberhaltigen Schicht zu schützen.

Das Aufbringen einer Maskierung auf die strukturierte Metallschicht und das Aufbringen einer Maskierung auf Bereiche des Keramikkörpers, die durch die die Strukturierung bildenden Ausnehmungen in der Metallschicht freigelegt sind, können gleichzeitig oder sequenziell erfolgen.

Für das Aufbringen einer Maskierung auf Bereiche des Keramikkörpers, die durch die die Strukturierung bildenden Ausnehmungen in der Metallschicht freigelegt sind, kann ein flüssiges Medium, wie es vorstehend in Bezug auf das Aufbringen einer Maskierung auf die strukturierte Metallschicht beschrieben ist, und eine Auftragung, wie sie vorstehend in Bezug auf das Aufbringen einer Maskierung auf die strukturierte Metallschicht beschrieben ist, verwendet werden.

In Schritt d) erfolgt das Abscheiden einer silberhaltigen Schicht auf die unmaskierten Bereiche der strukturierten Metallschicht unter Erhalt eines Kontaktbereichs aufweisend Silber.

Die silberhaltige Schicht ist vorzugsweise eine Schicht, die aus Silber oder einer silberhaltigen Legierung, besonders bevorzugt aus Silber, besteht. Die Abscheidung der silberhaltigen Schicht erfolgt vorzugsweise chemisch (zum Beispiel elektrochemisch) oder physikalisch. Die chemische Abscheidung der silberhaltigen Schicht kann zum Beispiel galvanisch oder stromlos erfolgen. Vorzugsweise erfolgt die chemische Abscheidung der silberhaltigen Schicht stromlos durch Aufbringen einer silberhaltigen Lösung unter einem Ladungsaustausch zwischen den Metallen, wobei Metall der Metallschicht teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer besonders bevorzugten Ausführungsform handelt es sich bei der silberhaltigen Lösung um eine saure Lösung von Silbernitrat und besonders bevorzugt um eine salpetersaure Lösung von Silbernitrat. Die Konzentration von Silber in der salpetersauren Lösung kann zum Beispiel im Bereich von 0,5 - 1,5 g/l, besonders bevorzugt im Bereich von 0,6 - 1,4 g/l und ganz besonders bevorzugt im Bereich von 0,8 - 1,2 g/l liegen. Die physikalische Abscheidung der silberhaltigen Schicht kann zum Beispiel durch Gasphasenabscheidung erfolgen. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben.

In Schritt e) erfolgt das Entfernen der Maskierung.

Die Maskierung kann auf eine fachübliche Weise entfernt werden. Hierzu kann die Maskierung beispielsweise einer alkalischen Lösung (zum Beispiel einer 2,5%igen Natriumhydroxidlösung) ausgesetzt werden. Nach dem Entfernen der Maskierung weist das Metall-Keramik-Substrat wenigstens einen Kontaktbereich aufweisend Silber auf, wobei die nicht mit dem Kontaktbereich aufweisend Silber versehene Oberfläche der Metallschicht frei zugänglich ist.

Mit dem hierin beschriebenen Verfahren lässt sich ein Metall-Keramik-Substrat erhalten, das mit einer Strukturierung und einem Kontaktbereich aufweisend Silber versehen ist. Durch die Schaffung eines Kontaktbereichs aufweisend Silber wird eine leichtere Anbindung des Chips mit dem Metall-Keramik-Substrat durch gängige Verfahren wie Sintern oder Löten ermöglicht. Das so erhaltene Metall-Keramik-Substrat zeichnet sich durch eine besonders hohe Temperaturwechselbeständigkeit aus.

**Ausführungsbeispiele**

Die vorliegende Erfindung wird nachstehend durch Ausführungsbeispiele näher beschrieben, die jedoch nicht als einschränkend verstanden werden sollen.

Beispiel 1:

*Beispiel 1a - Herstellung eines strukturierten Metall-Keramik-Substrats:*

Für Beispiel 1 wurde ein Metall-Keramik-Substrat verwendet, bei dem ein Keramikkörper aus einer Siliziumnitridkeramik mit der Abmessung 177,8 x 139 x 0,32 mm beidseitig mit jeweils einer Kupferschicht mit der Abmessung 170 x 132 x 0.3 mm über ein AMB (Active Metal Brazing) -Verfahren, verbunden war. Dieses Kupfer-Keramik-Substrat wurde nach der Herstellung zunächst gereinigt.

Sodann wurde auf beide Kupferschichten des Kupfer-Keramik-Substrats mittels eines Hot Roll Laminator eine photosensitive Folie aufgebracht. Die photosensitive Folie wurde jeweils mit 30 mJ/cm$^2$ an den zu maskierenden Bereichen belichtet, um das in der photosensitiven Folie enthaltene Polymer zu härten und eine Ätzmaske zu erhalten. Im Anschluss wurden die unbelichteten Stellen der photosensitiven Folie nasschemisch unter Verwendung einer Natriumcarbonatlösung (Konzentration = 10 g/l) entfernt. Nach dem Aufbringen der Ätzmaske wurde das Kupfer-Keramik-Substrat durch Spülen gereinigt. Anschließend wurden die unmaskierten Bereiche der Kupferschichten des Kupfer-Keramik-Substrat nasschemisch geätzt. Hierzu wurde das Kupfer-Keramik-Substrat in einer Ätzanlage mit einer salzsauren Kupferchloridlösung (Kupferionengehalt = 160 g/l) enthaltend Wasserstoffperoxid besprüht. Das Ätzen erfolgte bei einer Temperatur von 50°C und bei einem Sprühdruck von 2,8 bar. Durch das Ätzen wurde Material aus den unmaskierten Bereichen der Kupferschichten des Kupfer-Keramik-Substrats abgetragen. Die Kupfer-Keramik-Substrate wurden danach gespült. Sodann wurden unmaskierte Bereiche der im Kupfer-Keramik-Substrat enthaltenen Verbindungsschicht ebenfalls nasschemisch geätzt. Hierzu wurde das Kupfer-Keramik-Substrat wiederum in einer Ätzanlage mit einer Ätzlösung besprüht, die Ammoniumfluorid, Fluorborsäure und Wasserstoffperoxid enthielt. Anschließend wurde das Kupfer-Keramik-Substrat gespült und getrocknet. Danach wurde die Ätzmaske in einer Strippanlage mit einer 2,5%igen Natriumhydroxidlösung entfernt.

*Beispiel 1b - Herstellung eines strukturierten Metall-Keramik-Substrats mit einem Kontaktbereich aufweisend Silber:*

Das in Beispiel 1a hergestellte strukturierte Kupfer-Keramik-Substrat wurde mit einem Kontaktbereich aufweisend Silber versehen. Hierzu wurde auf eine strukturierte Kupferschicht des Kupfer-Keramik-Substrats (einschließlich des Strukturierungsbereichs) und Bereiche des Keramikkörpers, die durch die die Strukturierung bildenden Ausnehmungen in der Kupferschicht freigelegt wurden (freiliegende Bereiche des Keramikkörpers), zunächst eine Maskierung aufgebracht. Dazu wurde das strukturierte Kupfer-Keramik-Substrat in einem Inkjetdrucker (MicroCraft C4K7861T, Sense Advanced Technology GmbH) positioniert, um eine Maskierung auf die strukturierte Kupferschicht (einschließlich des Strukturierungsbereichs) und die freiliegenden Bereiche des Keramikkörpers aufzubringen. Die Bereiche der strukturierten Kupferschicht, die frei von Silber bleiben sollten, sowie die freiliegenden Bereiche des Keramikkörpers wurden mit einem flüssigen Medium, das ein Maskierungsmittel umfasste (DiPaMAT Etch Resist ER02), bedruckt. Anschließend wurde das Maskierungsmittel mit Hilfe von UV-Strahlung gehärtet (LED 390 nm, 500 mJ/cm$^2$). Folglich waren die Bereiche der strukturierten Kupferschicht, die frei von Silber bleiben sollten, sowie die freiliegenden Bereiche des Keramikkörpers mit einer 30 $\mu$m dicken Maskierung abgedeckt.

Danach wurden auf die unmaskierten Bereiche der Kupferschicht des Kupfer-Keramik-Substrats silberhaltige Kontaktbereiche abgeschieden. Hierzu wurde das mit der Maskierung versehene Kupfer-Keramik-Substrat zunächst mit einer ersten Lösung enthaltend Wasserstoffperoxid und Schwefelsäure vorbehandelt und danach mit einer salpetersauren Silbernitratlösung (Silbergehalt = 1,0 g/l) kontaktiert. Nach der Abscheidung der silberhaltigen Kontaktbereiche wurde das Kupfer-Keramik-Substrat mit Wasser sorgfältig gespült, um vorhandene Rückstände zu entfernen. Anschließend wurde die Maskierung in einer Strippanlage mit einer 2,5%igen Natriumhydroxidlösung entfernt.

Das so erhaltene Kupfer-Keramik-Substrat wurde mittels Laser zu Einzelteilen mit den Abmessungen (20,5 x 17,0 mm) geschnitten und konnte danach für weitere Untersuchungen und die Herstellung eines elektronischen Bauteils eingesetzt werden.

Vergleichsbeispiel 1:

*Vergleichsbeispiel 1a - Herstellung eines strukturierten Metall-Keramik-Substrats:*

In Vergleichsbeispiel 1a wurde ein strukturiertes Kupfer-Keramik-Substrat analog zu Beispiel 1a hergestellt.

*Vergleichsbeispiel 1b - Herstellung eines strukturierten Metall-Keramik-Substrats mit einem Kontaktbereich aufweisend Silber:*

Das in Vergleichsbeispiel 1a hergestellte strukturierte Kupfer-Keramik-Substrat wurde mit einem Kontaktbereich aufweisend Silber versehen. Hierzu wurde auf eine strukturierte Kupferschicht des Kupfer-Keramik-Substrats (einschließlich des Strukturierungsbereichs) und Bereiche des Keramikkörpers, die durch die die Strukturierung bildenden Ausnehmungen in der Kupferschicht freigelegt wurden (freiliegende Bereiche des Keramikkörpers), zunächst eine Maskierung aufgebracht. Dazu wurde auf die beiden geätzten Oberflächen des strukturierten Kupfer-Keramik-Substrats mittels eines Hot Roll Laminator eine photosensitive Folie aufgebracht. Die photosensitive Folie wurde jeweils mit 30 $mJ/cm^2$ an den zu maskierenden Bereichen belichtet, um das in der photosensitiven Folie enthaltene Polymer zu härten und die Maskierung zu erhalten. Danach wurden die unbelichteten Stellen der photosensitiven Folie nasschemisch unter Verwendung einer Natriumcarbonatlösung (Konzentration = 10 g/l) entfernt. Nach dem Aufbringen der Maskierung wurde das Kupfer-Keramik-Substrat wiederum durch Spülen gereinigt. Danach wurden auf die unmaskierten Bereiche der Kupferschicht des Kupfer-Keramik-Substrats silberhaltige Kontaktbereiche abgeschieden. Hierzu wurde das mit der Maskierung versehene Kupfer-Keramik-Substrat zunächst mit einer ersten Lösung enthaltend Wasserstoffperoxid und Schwefelsäure vorbehandelt und danach mit einer salpetersauren Silbernitratlösung (Silbergehalt = 1,0 g/l) kontaktiert. Nach der Abscheidung der silberhaltigen Kontaktbereiche wurde das Kupfer-Keramik-Substrat mit Wasser sorgfältig gespült, um vorhandene Rückstände zu entfernen. Anschließend wurde die Maskierung in einer Strippanlage mit einer 2,5%igen Natriumhydroxidlösung entfernt.

Das so erhaltene Kupfer-Keramik-Substrat wurde mittels Laser zu Einzelteilen mit den Abmessungen (20,5 x 17,0 mm) geschnitten und konnte danach für weitere Untersuchungen und die Herstellung eines elektronischen Bauteils eingesetzt werden.

Auswertung:

Für die im Beispiel 1 und im Vergleichsbeispiel 1 erhaltenen Kupfer-Keramik-Substrate wurde das Verhältnis S ($BC_{solid}$) / S ($BC_{total}$) ermittelt. Hierzu wurden, wie hierin beschrieben, die Kupfer-Keramik-Substrate senkrecht zur Hauptbegrenzungsfläche der jeweiligen Keramikkörper geschnitten und Aufnahmen der so erhaltenen Querschnitte durch ein Lichtmikroskop erstellt. In den Querschnitten wurden jeweils die Punkte A, B und C bestimmt. Danach wurde für jedes der Kupfer-Keramik-Substrate das Verhältnis S ($BC_{solid}$) / S ($BC_{total}$) ermittelt. Hierzu wurden zehn unterschiedliche Querschnitte eines Strukturierungsbereichs in der Kupferschicht des jeweiligen Kupfer-Keramik-Substrats untersucht, das Verhältnis S ($BC_{solid}$) / S ($BC_{total}$) für jeden dieser Querschnitte wurde bestimmt, und der Mittelwert aus den Verhältnissen S ($BC_{solid}$) / S ($BC_{total}$) für jeden dieser Querschnitte wurde gebildet, um zum Verhältnis S ($BC_{solid}$) / S ($BC_{total}$) für das jeweilige Kupfer-Keramik-Substrat zu gelangen. Ferner wurde die Standardabweichung SSD bestimmt.

Ebenso wurde für die im Beispiel 1 und im Vergleichsbeispiel 1 erhaltenen Kupfer-Keramik-Substrate der Gehalt an Silber in dem Bereich, der an der oberen Hälfte der Konturlinie anliegt, und in dem Bereich, der an der unteren Hälfte der Konturlinie anliegt, mittels energiedispersiver Röntgenspektroskopie (EDX), gekoppelt mit Rasterelektronenmikroskopie (REM), wie vorstehend beschrieben, bestimmt (REM-EDX).

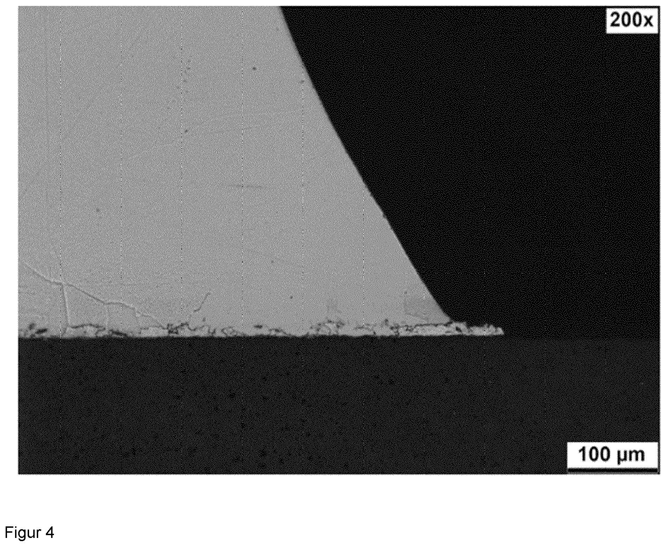

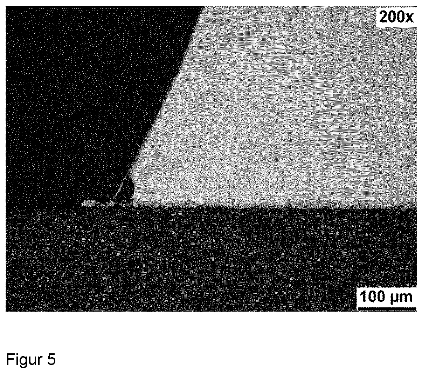

Figur 4 zeigt exemplarisch eine lichtmikroskopische Aufnahme des Querschnitts eines Ausschnitts aus einem Strukturierungsbereich der Kupferschicht eines Kupfer-Keramik-Substrats gemäß Beispiel 1, während Figur 5 exemplarisch eine lichtmikroskopische Aufnahme des Querschnitts eines Ausschnitts aus einem Strukturierungsbereich der Kupferschicht eines Kupfer-Keramik-Substrats gemäß Vergleichsbeispiel 1 zeigt.

Die Ergebnisse sind in Tabelle 1 dargestellt.

Tabelle 1:

| | S ($BC_{solid}$) / S ($BC_{total}$) | Standardabweichung SSD | Silbergehalt obere Hälfte | Silbergehalt untere Hälfte |
|---|---|---|---|---|
| Beispiel | 98,1% | 0,6% | 85 wt% | 1 wt% |
| Vergleichsbeispiel | 58,4% | 12,7% | 76 wt% | 81 wt% |

Die Kupfer-Keramik-Substrate wurden auf ihre Temperaturwechselbeständigkeit hin untersucht. Hierzu wurden Temperaturwechselbeständigkeitstests durchgeführt.

Temperaturwechselbeständigkeitstest:

Zur Vorbereitung des Temperaturwechselbeständigkeitstests wurde zunächst mittels Ultraschallmikroskopie (PVA Tepla SAM300) überprüft, ob die Kupfer-Keramik-Substrate in einwandfreiem Zustand waren. Für den Test wurden ausschließlich Kupfer-Keramik-Substrate verwendet, die keine Delamination zwischen Keramikkörper und Kupferschicht oder sonstige Deformationen, die zur Delamination der Kupferschicht vom Keramikkörper führen könnten (zum Beispiel Risse), zeigten. Zum Testen der Temperaturwechselbeständigkeit wurden die Kupfer-Keramik-Substrate wiederholt für einen Zeitraum von jeweils fünf Minuten einer kalten Flüssigkeit (Temperatur -65°C, Galden Do2TS) und einer heißen Flüssigkeit (Temperatur +150°C, Galden Do2TS) in einer Zyklierkammer (ESPEC TSB-21 51) ausgesetzt. Die Kupfer-Keramik-Substrate wurden alle 1000 Zyklen mittels Ultraschallmikroskopie (PVA Tepla SAM300) erneut auf Delamination und sonstige Deformationen überprüft. Der Test wurde nach 3000 Zyklen beendet. Danach wurden die Kupfer-Keramik-Substrate wiederum mittels Ultraschallmikroskopie (PVA Tepla SAM300) auf Delamination und sonstige Deformationen überprüft. Der Zustand der jeweiligen Kupfer-Keramik-Substrate nach Durchführung des Temperaturwechselbeständigkeitstests wurde mit dem Zustand der Kupfer-Keramik-Substrate vor Durchführung des Temperaturwechselbeständigkeitstests im Hinblick auf eine Delamination und sonstige Deformationen verglichen. Delaminationen und sonstige Deformationen (zum Beispiel Risse) waren hierbei als weiße Verfärbungen im Ultraschallbild erkennbar.
Die Ergebnisse sind in Tabelle 2 dargestellt.

Tabelle 2:

|  | Ergebnis des Temperaturwechselbeständigkeitstests |
|---|---|
| Beispiel 1 | Sehr gut: Es waren keine Delaminationen erkennbar |
| Vergleichsbeispiel 1 | Mangelhaft: An den Ecken des Kupfer-Keramik-Substrats waren ausgeprägte Delaminationen erkennbar |

Die Ergebnisse zeigen, dass das erfindungsgemäße Metall-Keramik-Substrat dem Metall-Keramik-Substrat des Vergleichsbeispiels 1 im Hinblick auf die Temperaturwechselbeständigkeit deutlich überlegen ist.

**Bezugszeichenliste:**

1       Metall-Keramik-Substrat
4       Strukturierungsbereich
8       Kontaktbereich
10      Keramikkörper
15      Hauptbegrenzungsfläche des Keramikkörpers
20      Metallschicht
22      Ausnehmung
24      Hauptbegrenzungsfläche der Metallschicht
40      Konturlinie
50      Festes Material
60      Silber
200     Weitere Metallschicht

**Patentansprüche**

**1.**  Metall-Keramik-Substrat aufweisend

a) einen Keramikkörper, der eine Hauptbegrenzungsfläche aufweist,
b) eine Metallschicht, die eine Hauptbegrenzungsfläche aufweist, wobei die Metallschicht flächig mit dem Keramikkörper verbunden ist, und wobei die Metallschicht einen Strukturierungsbereich aufweist, der

(i) bereichsweise festes Material und
(ii) bereichsweise nicht-festes Material
umfasst, und

c) einen auf der Metallschicht angeordneten Kontaktbereich aufweisend Silber,

**dadurch gekennzeichnet, dass**

in einem Querschnitt durch das Metall-Keramik-Substrat senkrecht zur Hauptbegrenzungsfläche des Keramikkörpers der Strukturierungsbereich eine Geometrie aufweist, wobei folgendes Erfordernis erfüllt ist:

$$S\,(BC_{solid})\,/\,S\,(BC_{total}) > 60\%,$$

wobei:

$S\,(BC_{total})$ für die gesamte Länge der Strecke zwischen den Punkten B und C steht und
$S\,(BC_{solid})$ für die Länge der Strecke zwischen den Punkten B und C steht, die festes Material schneidet, wobei die Punkte B und C wie folgt bestimmt werden:

1. die Ausgleichsgerade zwischen dem Keramikkörper und der Metallschicht wird bestimmt;
2. die Konturlinie wird bestimmt, die das feste Material vom nicht-festen Material trennt;
3. auf einer Senkrechten zur Ausgleichsgeraden wird im Abstand von 150 $\mu$m zur Ausgleichsgeraden der Punkt A ermittelt, in dem die Senkrechte zur Ausgleichsgeraden die Konturlinie schneidet;
4. auf einer Senkrechten zur Ausgleichsgeraden wird im Abstand von 80 $\mu$m zur Ausgleichsgeraden der Punkt B ermittelt, in dem die Senkrechte zur Ausgleichsgeraden die Konturlinie schneidet; und
5. auf einer Geraden, die durch die Punkte A und B verläuft, wird der Punkt C ermittelt, in dem die Gerade die Ausgleichsgerade schneidet; und

wobei die Konturlinie sich von der Hauptbegrenzungsfläche der Metallschicht bis zur Hauptbegrenzungsfläche des Keramikkörpers erstreckt, wobei die Konturlinie eine obere Hälfte und eine untere Hälfte aufweist, wobei sich die obere Hälfte der Konturlinie von der Hauptbegrenzungsfläche der Metallschicht in Richtung der Hauptbegrenzungsfläche des Keramikkörpers erstreckt und sich die untere Hälfte der Konturlinie von der Hauptbegrenzungsfläche des Keramikkörpers in Richtung der Hauptbegrenzungsfläche der Metallschicht erstreckt, und wobei das feste Material in dem Bereich, der an der oberen Hälfte der Konturlinie anliegt, einen höheren Gehalt an Silber aufweist als in dem Bereich, der an der unteren Hälfte der Konturlinie anliegt.

**2.** Metall-Keramik-Substrat gemäß Anspruch 1, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

**3.** Metall-Keramik-Substrat gemäß Anspruch 1 oder Anspruch 2, **dadurch gekennzeichnet, dass** die Metallschicht Kupfer umfasst.

**4.** Metall-Keramik-Substrat gemäß einem der vorangegangenen Ansprüche, **dadurch gekennzeichnet, dass** das feste Material Metall der Metallschicht enthält.

**5.** Metall-Keramik-Substrat gemäß einem der vorangegangenen Ansprüche, **dadurch gekennzeichnet, dass** das nicht-feste Material gasförmiges Material enthält.

**6.** Metall-Keramik-Substrat gemäß einem der vorangegangenen Ansprüche, **dadurch gekennzeichnet, dass** folgendes Erfordernis erfüllt ist:

$$S\,(BC_{solid})\,/\,S\,(BC_{total}) > 95\%.$$

**7.** Metall-Keramik-Substrat gemäß einem der vorangegangenen Ansprüche, **dadurch gekennzeichnet, dass** die Stichprobenstandardabweichung SSD des Verhältnisses $S\,(BC_{solid})\,/\,S\,(BC_{total})$ über wenigstens zehn unterschied-liche Querschnitte des Strukturierungsbereichs der Metallschicht nicht mehr als 10% beträgt.

**8.** Metall-Keramik-Substrat gemäß einem der vorangegangenen Ansprüche, **dadurch gekennzeichnet, dass** das Verhältnis des Gehalts an Silber im festen Material in dem Bereich, der an der unteren Hälfte der Konturlinie anliegt, zum Gehalt an Silber im festen Material in dem Bereich, der an der oberen Hälfte der Konturlinie anliegt, bei weniger als 0,8 liegt.

**9.** Elektronisches Bauteil aufweisend ein Metall-Keramik-Substrat gemäß einem der vorangegangenen Ansprüche.

**10.** Verfahren zur Herstellung eines Metall-Keramik-Substrats, das mit einer Strukturierung und einem Kontaktbereich aufweisend Silber versehen ist, umfassend die Schritte:

  a) Bereitstellung eines Metall-Keramik-Substrats aufweisend

   a1) einen Keramikkörper und
   a2) eine mit dem Keramikkörper flächig verbundene Metallschicht,

  b) Strukturieren der Metallschicht,
  c) Aufbringen einer Maskierung auf die strukturierte Metallschicht, indem ein flüssiges Medium, das ein Maskierungsmittel umfasst, bereichsweises auf die strukturierte Metallschicht aufgetragen und das Maskierungsmittel verfestigt wird,
  d) Abscheiden einer silberhaltigen Schicht auf die unmaskierten Bereiche der strukturierten Metallschicht unter Erhalt eines Kontaktbereichs aufweisend Silber und
  e) Entfernen der Maskierung.

Figur 1

Figur 2

Figur 3

Figur 4

Figur 5

Europäisches
Patentamt

European
Patent Office

Office européen
des brevets

## EUROPÄISCHER RECHERCHENBERICHT

Nummer der Anmeldung

EP 24 15 3588

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y<br><br>A | DE 10 2021 107872 A1 (ROGERS GERMANY GMBH [DE]) 29. September 2022 (2022-09-29)<br>* Absätze [0001], [0003], [0005], [0007], [0009], [0012] *<br>* Absätze [0046] - [0056] *<br>* Abbildung 1 *<br>- - - - - | 1-9<br><br>10 | INV.<br>H01L23/373<br>H05K1/03 |
| Y<br><br>A | EP 3 961 695 A1 (DENKA COMPANY LTD [JP]) 2. März 2022 (2022-03-02)<br>* Absätze [0001], [0005] - [0010], [0016], [0017] *<br>* Absätze [0050] - [0059] *<br>* Abbildungen 1A,1B *<br>- - - - - | 1-9<br><br>10 | |
| E | EP 4 311 819 A1 (HERAEUS ELECTRONICS GMBH & CO KG [DE]) 31. Januar 2024 (2024-01-31)<br>* Absatz [0055] *<br>- - - - - | 10 | |
| A | EP 3 661 337 A1 (DENKA COMPANY LTD [JP]) 3. Juni 2020 (2020-06-03)<br>* Absätze [0001], [0002], [0009] - [0013] *<br>* Absätze [0038] - [0044], [0046], [0060] *<br>* Abbildungen 1-3 *<br>- - - - - | 1-10 | RECHERCHIERTE SACHGEBIETE (IPC)<br><br>H01L<br>H05K |

Der vorliegende Recherchenbericht wurde für alle Patentansprüche erstellt

| Recherchenort | Abschlußdatum der Recherche | Prüfer |
|---|---|---|
| Den Haag | 8. August 2024 | Keller, Jan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..............................................................................................
& : Mitglied der gleichen Patentfamilie, übereinstimmendes Dokument

EPO FORM 1503 03.82 (P04C03)

**EP 4 593 076 A1**

**ANHANG ZUM EUROPÄISCHEN RECHERCHENBERICHT**
**ÜBER DIE EUROPÄISCHE PATENTANMELDUNG NR.**                    EP 24 15 3588

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-08-2024

| Im Recherchenbericht angeführtes Patentdokument | Datum der Veröffentlichung | Mitglied(er) der Patentfamilie | Datum der Veröffentlichung |
|---|---|---|---|
| DE 102021107872 A1 | 29-09-2022 | CN 117223401 A | 12-12-2023 |
| | | DE 102021107872 A1 | 29-09-2022 |
| | | EP 4316217 A1 | 07-02-2024 |
| | | KR 20230151532 A | 01-11-2023 |
| | | WO 2022207601 A1 | 06-10-2022 |
| EP 3961695 A1 | 02-03-2022 | CN 113748502 A | 03-12-2021 |
| | | EP 3961695 A1 | 02-03-2022 |
| | | JP 7212768 B2 | 25-01-2023 |
| | | JP WO2020218193 A1 | 29-10-2020 |
| | | KR 20220002976 A | 07-01-2022 |
| | | WO 2020218193 A1 | 29-10-2020 |
| EP 4311819 A1 | 31-01-2024 | EP 4311819 A1 | 31-01-2024 |
| | | WO 2024022742 A1 | 01-02-2024 |
| EP 3661337 A1 | 03-06-2020 | CN 110945974 A | 31-03-2020 |
| | | EP 3661337 A1 | 03-06-2020 |
| | | JP 7010950 B2 | 26-01-2022 |
| | | JP WO2019022133 A1 | 11-06-2020 |
| | | KR 20200029480 A | 18-03-2020 |
| | | US 2020163210 A1 | 21-05-2020 |
| | | WO 2019022133 A1 | 31-01-2019 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3744120 A
- DE 2319854 C2
- JP 4812985 B
- DE 102017114893 A1